# FASCICULE DE BREVET EUROPEEN

(11) **EP 1 267 356 B1**
(45) Date de publication et mention de la délivrance du brevet: **26.03.2008**
(21) Numéro de dépôt: 02354098.2
(22) Date de dépôt: 14.06.2002
(51) Int. Cl.: G11C 11/56, G11C 17/12

(54) **Mémoire ROM à points mémoire multibit**
ROM Speicher mit multibit Speicherpunkten
ROM memory with multibit memory points

(30) Priorité: 15.06.2001 FR 0107873
(43) Date de publication de la demande: 18.12.2002
(73) Titulaire: DOLPHIN INTEGRATION, F-38240 Meylan (FR)
(72) Inventeur: Poullet, Frédéric, 38220 Vizille (FR)
(74) Mandataire: de Beaumont, Michel

(56) Documents cités:
- EP-A- 1 059 669
- US-A- 4 809 227
- US-A- 5 528 534
- US-A- 5 831 892
- US-A- 5 870 326
- US-A- 5 917 224
- US-A- 6 002 607

## Description

La présente invention concerne le domaine des mémoires et plus particulièrement des mémoires mortes (ROM).

De façon classique, dans une mémoire morte, des éléments de mémorisation ou points mémoire sont disposés à l'intersection de rangées et de colonnes, chaque point mémoire étant susceptible de mémoriser un état binaire, c'est-à-dire un 0 ou un 1. Ainsi, chaque point mémoire est monobit.

Pour réduire la dimension des mémoires, on a envisagé que chaque point mémoire, au lieu de pouvoir se trouver dans l'un ou l'autre de deux états, soit susceptible de fournir une information plus riche, caractéristique par exemple de l'un ou l'autre de trois ou quatre états. De préférence, pour des raisons de gestion de la mémoire, on préférerait que chaque point mémoire puisse mémoriser un nombre entier de bits, c'est-à-dire un nombre d'informations égal à une puissance entière de 2. Chaque point mémoire correspondrait par exemple à un transistor dont le niveau de conduction soit plus ou moins important quand il est commandé pour être à l'état passant. Pour cela, on peut envisager de prévoir au niveau de chaque point mémoire des transistors de dimension plus ou moins importante, ou encore de prévoir des transistors à grille flottante dont la grille est plus ou moins préchargée. Toutefois, aucune de ces solutions n'a connu de succès industriel en technologie CMOS standard, vraisemblablement parce que toutes ces solutions impliquent des opérations technologiques relativement complexes, et exigent de comparer un niveau de tension ou de courant à plusieurs seuils distincts. Cette opération est toujours relativement complexe et risque de souffrir d'un défaut de fiabilité si les caractéristiques des composants dérivent.

Le document US-A-5 870 326 décrit un point mémoire multibits.

Ainsi, un objet de la présente invention est de permettre le stockage dans un point mémoire simple de plusieurs informations, c'est-à-dire d'une information à plusieurs bits ou information multibit.

Un autre objet de la présente invention est de prévoir une matrice de tels points mémoire dans laquelle les points mémoire soient tous identiques.

Un autre objet de la présente invention est de prévoir une telle matrice de points mémoire dans laquelle les opérations de lecture soient binaires et fiables.

Un autre objet de la présente invention est de prévoir une telle matrice de points mémoire qui soit particulièrement simple à réaliser et qui occupe peu de place sur un circuit intégré.

Pour atteindre ces objets, la présente invention prévoit une mémoire ROM selon la revendication 1.

Selon un mode de réalisation de la présente invention, les grilles des transistors MOS d'une même rangée sont interconnectées.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une colonne de points mémoire du type à codage par position de connexions ;
la figure 2 représente un mode de réalisation d'une colonne de points mémoire dibits selon la présente invention ;
les figures 3A et 3B représentent des circuits de lecture adaptés à la colonne mémoire de la figure 2 ;
la figure 4 représente un mode de réalisation d'un ensemble de colonnes de points mémoire dibits selon la présente invention ;
la figure 5 représente un mode de réalisation d'une colonne de points mémoire tribits selon la présente invention ;
les figures 6A, 6B et 6C représentent des circuits de lecture adaptés à la colonne mémoire de la figure 5 ; et
la figure 7 représente un mode de réalisation d'un ensemble de colonnes mémoire tribits selon la présente invention.

Une des bases de l'invention a consisté pour l'inventeur à considérer et à classer les divers types de cellules mémoire existantes pour rechercher si l'une de ces cellules est transformable en cellule multibit.

Les cellules mémoire les plus courantes sont les cellules dans lesquelles, au niveau d'un point de croisement, une information mémorisée se concrétise par la présence ou l'absence d'un transistor, ou plus généralement par la présence d'un transistor actif ou inactif. Un transistor actif est un transistor qui devient passant quand on applique un signal à sa borne de commande, généralement sa grille puisque les mémoires sont généralement conçues à partir de transistors MOS. Un transistor inactif est un transistor qui reste bloqué alors que le signal appliqué sur sa grille suffit à rendre passant un transistor actif correspondant. Un tel transistor inactif est généralement réalisé comme un transistor actif mais en sautant ou en ajoutant une ou des étapes de fabrication de façon qu'il soit non fonctionnel. On peut dire que ces mémoires classiques sont des mémoires à codage par présence ou absence d'un transistor.

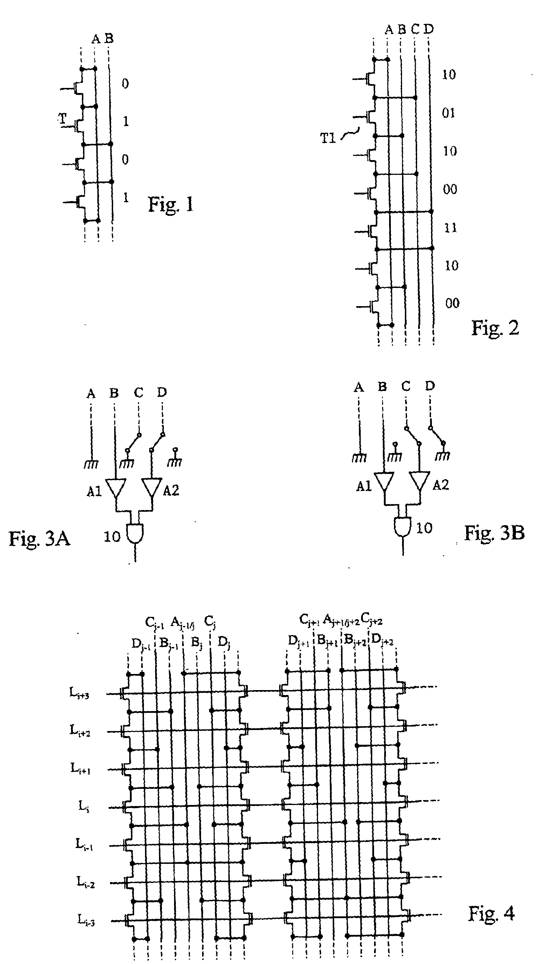

Un deuxième type de point mémoire a été décrit dans le brevet américain 5917224 de L. Zangara cédé à la demanderesse. L'architecture d'une colonne de points mémoire de ce deuxième type est représentée en figure 1. Cette colonne comprend une chaîne de transistors T, deux transistors adjacents ayant des régions de source-drain confondues. A chaque colonne sont associées deux lignes A et B entre lesquelles, lors de la lecture, on cherche à déterminer s'il y a conduction ou pas. Généralement, l'une de ces lignes est affectée à un potentiel de référence, l'autre ligne est préchargée puis, après la fin de la précharge on lit la différence de potentiel entre les deux lignes tandis que l'un des points mémoire T est adressé. Tous les points mémoire sont des transistors identiques et actifs mais chaque transistor a ses bornes principales connectées ou bien à la même ligne ou bien à deux lignes distinctes. Si les deux bornes sont connectées à la même ligne et que ce transistor est adressé, la ligne préchargée restera au potentiel de précharge ce qui caractérise un premier état. Si les deux bornes du transistor adressé sont connectées à des lignes différentes, ce transistor court-circuite les deux lignes et le potentiel de la ligne préchargée chute, ce qui caractérise un deuxième état. On peut dire que ce deuxième type de mémoire est une mémoire à codage par position de connexions.

La présente invention propose une modification de ce deuxième type de mémoire pour en faire une mémoire multibit. L'invention va d'abord être décrite dans le cas où un point mémoire permet de stocker une information à deux bits puis dans le cas où un point mémoire permet de stocker une information à trois bits et il en découlera une généralisation de la présente invention.

### POINT MÉMOIRE DIBIT

La figure 2 illustre un mode de réalisation d'une mémoire à points mémoire à deux bits selon un mode de réalisation de la présente invention. Chaque colonne de la mémoire comporte une chaîne de transistors T1 associés à quatre (2²) lignes A, B, C, D. Chaque colonne est associée à un circuit de lecture tel qu'illustré en figures 3A et 3B. Pour deux transistors adjacents d'une même colonne, le drain de l'un correspond à la source de l'autre. Chaque transistor a son drain connecté à l'une des lignes A, B, C, D et sa source connectée à l'une des lignes A, B, C, D (éventuellement la même). Tous les transistors sont identiques et sont des transistors actifs.

En lecture, l'un des transistors de la colonne est sélectionné et le circuit de lecture est successivement mis dans la configuration illustrée en figure 3A puis dans la configuration illustrée en figure 3B. Ce passage d'une configuration à l'autre peut être réalisé par tout moyen de commutation connu. Des circuits de lecture associés à des moyens de stockage pourraient également être utilisés simultanément.

Dans la configuration de la figure 3A, deux des lignes, A et C, sont connectées à un potentiel de référence, que l'on appellera par souci de simplification la masse, mais qui doit seulement être distinct d'un potentiel de précharge mentionné ci-après. Les deux autres lignes, B et D, sont susceptibles d'être préchargées puis d'être connectées à une porte ET 10, par l'intermédiaire d'amplificateurs de lecture respectifs A1 et A2. Ainsi, si le transistor de la colonne qui reçoit un signal de commande a ses bornes reliées à la même ligne, à la ligne B et à la ligne D ou à la ligne A et à la ligne C, ce transistor ne reliera aucune des lignes B et D à la masse. Ces lignes resteront à la tension de précharge, les deux amplificateurs A1 et A2 fourniront un signal au niveau haut (1) et la porte ET 10 fournira en sortie un 1. Par contre, si le transistor considéré relie la ligne B ou la ligne D à la ligne A ou à la ligne C, on détectera un 0. Ceci correspond à la lecture d'un premier bit du point mémoire considéré.

Dans une seconde phase de lecture, pour lire le second bit, on pourra utiliser le circuit de lecture modifié comme cela est représenté en figure 3B, dans laquelle les lignes A et D sont reliées à la masse et les lignes B et C sont susceptibles d'être préchargées puis "lues". Si le transistor T1 considéré a ses bornes principales connectées à la même ligne, aux lignes A et D, ou aux lignes B et C, les lignes B et C ne seront pas déchargées. Par contre, si le transistor considéré a l'une de ses bornes connectée à la ligne B ou C et l'autre de ses bornes connectée à la ligne A ou D, il se produira une décharge de la ligne B ou C. Dans le premier cas, on détectera un 1 en sortie de la porte ET 10 et dans le deuxième cas un 0.

En partant de ces considérations, et en considérant les circuits de lecture spécifiques illustrés en figures 3A et 3B, on voit que pour chaque point mémoire les données 00, 01, 10 et 11 peuvent être codées de l'une des quatre façons indiquées dans le tableau 1 suivant.

**TABLEAU 1**

| **Données** | **Connexions drain/source du transistor MOS** | | | |
|---|---|---|---|---|
| 00 | AB | BA | CD | DC |
| 01 | AD | BC | CB | DA |
| 10 | AC | BD | CA | DB |
| 11 | AA | BB | CC | DD |

Pour le caractère complet du tableau, on a indiqué par exemple que la donnée 00 pouvait être créée par la connexion AB ou BA et par la connexion CD ou DC. Il s'agit en fait de connexions symétriques.

On notera en comparant ce tableau aux circuits de lecture des figures 3A et 3B que ces circuits décodent effectivement les données à deux bits indiquées pour les connexions indiquées. A titre d'exemple, on a indiqué en figure 2 le codage correspondant à chacun des transistors de la colonne, successivement 10, 01, 10, 00, 11, 10 et 00 pour le mode de lecture illustré en figures 3A et 3B.

De façon générale, à partir du moment où l'on a choisi un mode de lecture des deux bits, en affectant une ligne comme référence (ici la ligne A), puis en "lisant" dans un premier temps deux des lignes B, C, D (ici les lignes B et D), puis dans un deuxième temps deux autres des lignes B, C, D (ici les lignes B et C), on pourra construire un tableau de codage des transistors. Il importe que, pour chaque transistor, il puisse être prévu pour effectuer tout codage choisi, une connexion à l'une quelconque des lignes et à une autre ligne choisie étant donné que deux transistors adjacents ont une borne commune et donc que, une fois qu'un transistor a été programmé, la connexion de l'une des bornes du transistor immédiatement adjacent est prédéterminée.

Puisque l'une des lignes A, B, C et D, ici la ligne A, est toujours au potentiel de référence, deux colonnes adjacentes peuvent partager une ligne commune. Ceci est représenté en figure 4 dans laquelle on a illustré sept rangées successives i+3 à i-3 et quatre colonnes successives j-1 à j+2. La colonne j-1 comprend quatre lignes Dⱼ₋₁, Cⱼ₋₁, Bⱼ₋₁ et Aⱼ₋₁ et la colonne j comprend quatre lignes successives Aⱼ, Bⱼ, Cⱼ et Dj. Les lignes Aⱼ₋₁ et Aⱼ constituent une seule et même ligne. De même, pour les colonnes j+1 et j+2, la ligne Aⱼ₊₁ et la ligne Aⱼ₊₂ sont confondues.

Diverses variantes et modifications apparaîtront à l'homme de l'art. Chaque point mémoire a été illustré dans la figure comme étant un transistor MOS. De façon générale, il pourra s'agir de toute structure constituant un commutateur commandable et les divers types de commutateurs commandables connus dans la technique pourront être utilisés.

Un avantage important de la présente invention réside dans le fait que chaque couple de bits mémorisé est détecté par deux lectures successives d'états binaires. A chaque lecture, on détecte un niveau haut ou bas et non pas divers niveaux intermédiaires.

### POINT MÉMOIRE TRIBIT

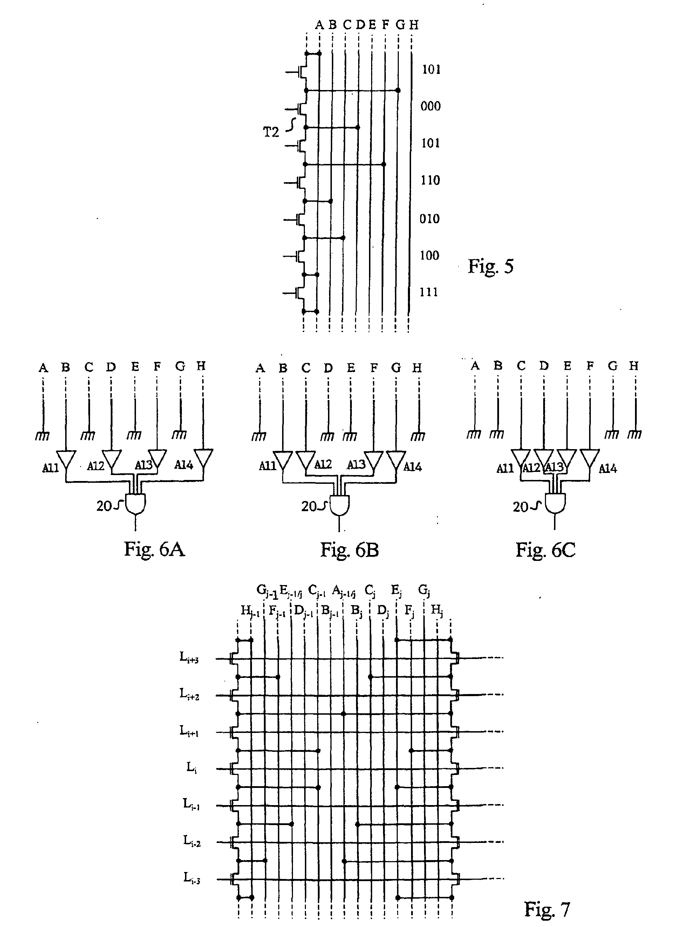

La figure 5 illustre une colonne d'une mémoire selon la présente invention dans laquelle chaque point mémoire est susceptible de mémoriser trois bits d'information. Chaque colonne comporte une chaîne de transistors T2 associés à huit (2³) lignes A, B, C, D, E, F, G, H. Chaque transistor a son drain connecté à l'une des lignes A, B, C, D, E, F, G, H et sa source connectée à l'une des lignes A, B, C, D, E, F, G, H (éventuellement la même).

La lecture d'un tel point mémoire se fait en utilisant successivement des circuits de lecture tels qu'illustrés en figures 6A, 6B et 6C. Dans chaque circuit de lecture, quatre lignes sont reliées à la masse et quatre lignes sont préchargeables et connectées à des amplificateurs de lecture A11, A12, A13 et A14 dont les sorties sont reliées à une porte ET 20. Les circuits de lecture se distinguent en ce que, dans chaque circuit, quatre lignes distinctes de celles du circuit précédent sont reliées aux amplificateurs de lecture. En pratique ceci peut être réalisé par des circuits de commutation appropriés. On utilise successivement ces circuits de lecture pour lire les premier, deuxième et troisième bits mémorisés dans chaque point mémoire. On comprendra, par analogie avec le circuit dibit, que :
- pour le circuit de lecture du premier bit représenté en figure 6A, la sortie sera à 1 si les bornes du point mémoire considéré sont reliées entre les lignes A, C, E et G, ou entre les lignes B, D, F et H, ou à la même ligne ; et la sortie sera à 0 si les connexions du point mémoire concerné sont disposées entre l'une quelconque des lignes B, D, F et H et l'une quelconque des lignes A, C, E et G ;
- pour le circuit de lecture du deuxième bit représenté en figure 6B, on aura une sortie à 1 si le point mémoire considéré à ses bornes reliées entre l'une des lignes A, D, E ou H ou entre l'une des lignes B, C, F ou G ou à deux lignes ou à la même ligne ; et la sortie sera à 0 si les connexions du point mémoire concerné sont disposées entre l'une quelconque des lignes B, C, F et G et l'une quelconque des lignes A, D, E et H ; et
- pour le circuit de lecture du troisième bit représenté en figure 6C, on aura une sortie à 1 si le point mémoire a ses bornes reliées entre les lignes A, B, G ou H, ou entre les lignes C, D, E ou F, ou à la même ligne ; et la sortie sera à 0 si le point mémoire est connecté entre l'une des lignes C, D, E, F et l'une des lignes A, B, G, ou H.

Ceci correspond au tableau 2 ci-après.

**TABLEAU 2**

| **Données** | **Connexions drain/source du transistor MOS** | | | | | | | |
|---|---|---|---|---|---|---|---|---|
| 000 | AF | BE | CH | DG | EB | FA | GD | HC |
| 001 | AB | BA | CD | DC | EF | FE | GH | HG |
| 010 | AD | BC | CB | DA | EH | FG | GF | HE |
| 011 | AH | BG | CF | DE | ED | FC | GB | HA |
| 100 | AC | BD | CA | DB | EG | FH | GE | HF |
| 101 | AG | BH | CE | DF | EC | FD | GA | HB |
| 110 | AE | BF | CG | DH | EA | FB | GC | HD |
| 111 | AA | BB | CC | DD | EE | FF | GG | HH |

On notera que, dans les circuits de lecture de la cellule tribit, comme pour la cellule dibit, une ligne (la ligne A) est constamment reliée à la masse. Cette ligne pourra être commune à deux colonnes de cellules voisines. Ceci est représenté en figure 7 où l'on voit que parmi les lignes A à H des colonnes j-1 et j, les lignes Aj et Aⱼ₋₁ constituent une seule et même ligne.

### POINT MÉMOIRE MULTIBIT

Ce qui a été décrit précédemment se généralise à des points mémoire à N bits. Pour cela, chaque colonne comprendra 2^{N} lignes et les points mémoire auront leurs bornes reliées à l'une de ces 2^{N} lignes. N circuits de lecture seront prévus, connectés sélectivement à 2^{N-1} lignes différentes parmi les 2^{N} lignes. A partir de ces connexions, l'homme de l'art pourra déterminer un tableau de codage correspondant aux tableaux 1 et 2 ci-dessus.

La présente invention est susceptible de nombreuses modifications qui apparaîtront à l'homme de l'art. Notamment, en fonction des choix réalisés pour les connexions de cellules de lecture, on pourra chaque fois déduire un tableau correspondant permettant d'identifier N bits par point mémoire associé à 2^{N} lignes.

Dans un mode de réalisation pratique, l'homme de l'art saura réaliser le circuit illustré de diverses façons, par exemple en prévoyant les diverses lignes constituant chaque colonne dans divers niveaux de métallisation et en prévoyant des connexions (des vias) entre les divers niveaux de métallisation. On a indiqué que chaque transistor était connecté à une colonne constituée de plusieurs lignes. Il y a une interchangeabilité entre les termes colonnes et rangées, le terme colonne n'impliquant pas nécessairement que les lignes correspondantes soient verticales.

Bien que l'on ait décrit chaque point mémoire comme étant un transistor MOS dont la région de drain ou de source est commune avec la région de source ou de drain du transistor MOS adjacent de la même colonne, tout commutateur commutable pourra être utilisé.

## Revendications

1. Mémoire ROM comprenant un ensemble de points mémoire disposes, en rangées et en colonnes, dans laquelle chaque point mémoire (T) constitué d'un, unique interrupteur commandable et comprenant deux bornes principales, mémorise une information de N bits avec N≥2, dans laquelle :
chaque colonne de points mémoire comprend au maximum 2^{N} lignes conductrices ;
chacune des deux bornes principales de chaque point mémoire est connectée à l'une desdites lignes conductrices d'une même colonne de points mémoire, chaque valeur d'information étant associée à un ensemble spécifique de 2^{N} connexions parmi l'ensemble de 2^{2N} connexions possibles ; et
chacun de N moyens de lecture est prévu pour appliquer un potentiel de précharge à un groupe choisi de 2^{N-1} premières lignes, connecter les 2^{N-1} autres lignes à un potentiel de référence, sélectionner un point mémoire, lire les potentiels sur les premières lignes, combiner les résultats obtenus pour fournir une indication de la valeur de l'un des bits de l'information contenue dans le point mémoire sélectionné ;
chaque interrupteur étant un transistor MOS, deux transistors adjacents d'une même colonne ayant une région de source et drain commune.

2. Mémoire ROM selon la revendication 1, **caractérisée en ce que** les grilles des transistors MOS d'une même rangée sont interconnectées.

3. Mémoire ROM selon la revendication 1, **caractérisée en ce que** chaque point mémoire est susceptible de mémoriser deux bits, dans lequel chaque colonne comprend quatre lignes respectivement dénommées A, B, C, D et dans lequel, pour la lecture du premier bit, les lignes A et C sont reliées à la masse et les lignes B et D à des circuits de précharge et de lecture et, pour la lecture du deuxième bit, les lignes A et D sont reliées à la masse et les lignes B et C sont reliées à des circuits de précharge et de lecture, les connexions des transistors pour chacune des données binaires à deux bits possibles étant données par le tableau suivant :
| **Données** | **Connexions drain/source du transistor MOS** | | | |
|---|---|---|---|---|
| 00 | AB | BA | CD | DC |
| 01 | AD | BC | CB | DA |
| 10 | AC | BD | CA | DB |
| 11 | AA | BB | CC | DD |

4. Mémoire ROM selon la revendication 1, **caractérisée en ce que** chaque point mémoire est susceptible de mémoriser trois bits, dans lequel chaque colonne comprend huit lignes respectivement dénommées A, B, C, D, E, F, G, H et dans lequel, pour la lecture du premier bit, les lignes A, C, E, G sont reliées à la masse et les lignes B, D, F, H à des circuits de précharge et de lecture, pour la lecture du deuxième bit, les lignes A, D, E, H sont reliées à la masse et les lignes B, C, F, G sont reliées à des circuits de précharge et de lecture, et pour la lecture du troisième bit, les lignes A, B, G, H sont reliées à la masse et les lignes C, D, E, F, sont reliées à des circuits de précharge et de lecture, les connexions des transistors pour chacune des données binaires à trois bits possibles étant données par le tableau suivant :
| **Données** | **Connexions drain/source du transistor MOS** | | | | | | | |
|---|---|---|---|---|---|---|---|---|
| 000 | AF | BE | CH | DG | EB | FA | GD | HC |
| 001 | AB | BA | CD | DC | EF | FE | GH | HG |
| 010 | AD | BC | CB | DA | EH | FG | GF | HE |
| 011 | AH | BG | CF | DE | ED | FC | GB | HA |
| 100 | AC | BD | CA | DB | EG | FH | GE | HF |
| 101 | AG | BH | CE | DF | EC | FD | GA | HB |
| 110 | AE | BF | CG | DH | EA | FB | GC | HD |
| 111 | AA | BB | CC | DD | EE | FF | GG | HH |

## Claims

1. A ROM including a set of memory points arranged in rows and columns, in which each memory point (T), formed of a single controllable switch and having two main terminals, memorizes an N-bit information, with N≥2, wherein:
each column of memory points includes at most 2^{N} conductive lines;
each of the two main terminals of each memory point is connected to one of said conductive lines of a same column of memory points, each information value being associated with a specific assembly of 2^{N} connections from among the set of the 2^{2N} possible connections; and
each of N read means is provided to apply a precharge voltage to a chosen group of 2^{N-1} first lines, connect the 2^{N-1} other lines to a reference voltage, select a memory point, reading the voltages from the first lines, combine the obtained results to provide an indication of the value of one of the bits of the information contained in the selected memory point;
each switch being a MOS transistor, two adjacent transistors of a same column having a common source and drain region.

2. The ROM of claim 1, **characterized in that** the gates of the MOS transistors of a same row are interconnected.

3. The ROM of claim 1, **characterized in that** each memory point is likely to memorize two bits, in which each column includes four lines respectively called A, B, C, D and in which, for the reading of the first bit, lines A and C are grounded and lines B and D are connected to precharge and read circuits and, for the reading of the second bit, lines A and D are grounded and lines B and C are connected to precharge and read circuits, the connections of the transistors for each of the possible two-bit binary data being given by the following table:
| **Data** | **Drain/source connections of the MOS transistor** | | | |
|---|---|---|---|---|
| 00 | AB | BA | CD | DC |
| 01 | AD | BC | CB | DA |
| 10 | AC | BD | CA | DB |
| 11 | AA | BB | CC | DD |

4. The ROM of claim 1, **characterized in that** each memory point is likely to memorize three bits, in which each column includes eight lines respectively called A, B, C, D, E, F, G, H and in which, for the reading of the first bit, lines A, C, E, G are grounded and lines B, D, F, H are connected to precharge and read circuits, for the reading of the second bit, lines A, D, E, H are grounded and lines B, C, F, G are connected to precharge and read circuits, and for the reading of the third bit, lines A, B, G, H are grounded and lines C, D, E, F are connected to precharge and read circuits, the connections of the transistors for each of the possible three-bit binary data being given by the following table:
| **Data** | **Drain/source connections of the MOS transistor** | | | | | | | |
|---|---|---|---|---|---|---|---|---|
| 000 | AF | BE | CH | DG | EB | FA | GD | HC |
| 001 | AB | BA | CD | DC | EF | FE | GH | HG |
| 010 | AD | BC | CB | DA | EH | FG | GF | HE |
| 011 | AH | BG | CF | DE | ED | FC | GB | HA |
| 100 | AC | BD | CA | DB | EG | FH | GE | HF |
| 101 | AG | BH | CE | DF | EC | FD | GA | HB |
| 110 | AE | BF | CG | DH | EA | FB | GC | HD |
| 111 | AA | BB | CC | DD | EE | FF | GG | HH |

## Patentansprüche

1. ROM - Speicher, welcher ein Ensemble von in Zeilen und Spalten angeordneten Speicherpunkten umfaßt, und in welchem jeweils jeder aus einem einzigen steuerbaren Schalter bestehender und zwei Hauptanschlüsse aufweisender Speicherpunkt bzw. -platz (T) eine Information von N bits, mit N ≥ 2, speichert, wobei in dem Speicher
jeweils jede Spalte von Speicherpunkten höchstens 2 ^{N} Leitungen umfaßt;
jeweils jeder der beiden Hauptanschlüsse jedes Speicherpunkts mit einer der genannten Leitungen ein und derselben Spalte verbunden ist, wobei jeweils jeder Informationswert einer spezifischen Gruppe von 2^{N} Verbindungen aus dem Ensemble von 2 ^{2N} möglichen Verbindungen zugeordnet ist; und
jeweils jedes von N Lesemitteln vorgesehen ist, um an eine ausgewählte Gruppe von 2 ^{N-1} ersten Leitungen ein Vorspannpotential anzulegen, die 2 ^{N-1} anderen Leitungen mit einem Bezugspotential zu verbinden, einen Speicherpunkt auszuwählen, die Potentiale auf den ersten Leitungen zu lesen, die erhaltenen Ergebnisse zu kombinieren zur Gewinnung einer Anzeige des Werts bzw Betrags eines der in dem ausgewählten Speicherpunkt enthaltenen Informations-Bits;
wobei jeweils jeder Schalter ein MOS - Transistor ist und zwei benachbarte Transistoren ein und derselben Spalte jeweils einen Souce/Drain -bereich gemeinsam haben.

2. ROM - Speicher nach Anspruch 1, **dadurch gekennzeichnet, daß** die Gate-Anschlüsse der MOS-Transistoren ein und derselben Zeile miteinander verbunden sind

3. ROM - Speicher nach Anspruch 1, **dadurch gekennzeichnet, daß** jeweils jeder Speicherpunkt zwei Bits speichern kann, daß in dem Speicher jede Spalte jeweils vier mit A, B, C, D bezeichnete Leitungen umfasst, und in welchem zum Lesen des ersten Bits die Leitungen A und C mit Masse verbunden werden und die Leitungen B und D mit Vorspann- und Leseschaltungen verbunden werden und in welchem zum Lesen des zweiten Bits die Leitungen A und D mit Masse verbunden werden und die Leitungen B und C mit Vorspann- und Leseschaltungen verbunden werden, wobei die Verbindungen der Transistoren für jedes der möglichen zwei-Bit-Daten durch die folgende Tabelle gegeben sind:
| **Daten** | **Drain/Source-Verbindungen des MOS-Transistors** | | | |
|---|---|---|---|---|
| 00 | AB | BA | CD | DC |
| 01 1 | AD | BC | CB | DA |
| 10 | AC | BD | CA | DB |
| 11 | AA | BB | CC | DD |

4. ROM - Speicher nach Anspruch 1, **dadurch gekennzeichnet, daß** jeweils jeder Speicherpunkt drei Bits speichern kann, daß in dem Speicher jede Spalte jeweils acht mit A, B, C, D, E, F, G, H bezeichnete Leitungen umfasst, und in welchem zum Lesen des ersten Bits die Leitungen A, C, E , G mit Masse und die Leitungen B, D, F, H mit Vorspann- und Leseschaltungen verbunden werden, in welchem zum Lesen des zweiten Bits die Leitungen A, D, E, H mit Masse und die Leitungen B, C, F, G mit Vorspann- und Leseschaltungen verbunden werden, und in welchem zum Lesen des dritten Bits die Leitungen A, B, G, H mit Masse und die Leitungen C, D, E, F mit Vorspann- und Leseschaltungen verbunden werden, wobei die Verbindungen für jedes der möglichen drei-Bit- Binärdaten durch die folgende Tabelle gegeben sind:
| **Daten** | **Drain/Source-Verbindungen des MOS-Transistors** | | | | | | | |
|---|---|---|---|---|---|---|---|---|
| 000 | AF | BE | CH | DG | EB | FA | GD | HC |
| 001 | AB | BA | CD | DC | EF | FE | GH | HG |
| 010 | AD | BC | CB | DA | EH | FG | GF | HE |
| 011 | AH | BG | CF | DE | ED | FC | GB | HA |
| 100 | AC | BD | CA | DB | EG | FH | GE | HF |
| 101 | AG | BH | CE | DF | EC | FD | GA | HB |
| 110 | AE | BF | CG | DH | EA | FB | GC | HD |
| 111 | AA | BB | CC | DD | EE | FF | GG | HH |
